Europäisches Patentamt

European Patent Office

Office européen des brevets

(19)

(11) **EP 0 777 326 B1**

(12) **EUROPÄISCHE PATENTSCHRIFT**

(45) Veröffentlichungstag und Bekanntmachung des Hinweises auf die Patenterteilung:
**30.06.2004 Patentblatt 2004/27**

(51) Int Cl.⁷: **H03H 17/02**

(21) Anmeldenummer: **96890182.7**

(22) Anmeldetag: **04.12.1996**

(54) **Verfahren und Vorrichtung zur Filterung eines Audiosignals**

Method and apparatus for filtering an audio signal

Procédé et appareil pour le filtrage d'un signal audio

(84) Benannte Vertragsstaaten:
**AT DE DK FR GB NL SE**

(30) Priorität: **07.12.1995 DE 19545623**

(43) Veröffentlichungstag der Anmeldung:
**04.06.1997 Patentblatt 1997/23**

(73) Patentinhaber: **AKG Akustische u. Kino-Geräte Gesellschaft m.b.H.**
**A-1230 Wien (AT)**

(72) Erfinder: **Opitz, Martin, Dipl.Ing. Dr.techn.**
**1190 Wien (AT)**

(74) Vertreter: **Patentanwälte**
**BARGER, PISO & PARTNER**
**Mahlerstrasse 9**
**P. O. Box 96**
**1015 Wien (AT)**

(56) Entgegenhaltungen:
**DE-A- 2 130 935      DE-C- 4 328 620**
**US-A- 4 121 296**

EP 0 777 326 B1

**Beschreibung**

Filterungen von Audiosignalen sind häufig erforderlich. Z.B. soll-bei der Wiedergabe ein bestimmter Raumcharakter vermittelt werden. Bei Schallaufnahmen erfolgt die Aufnahme sehr oft in unmittelbarer Nähe der Schallquelle. Dadurch bleibt der Anteil des Raumes bei der Aufnahme unberücksichtigt. Wird das so aufgenommene Signal nicht weiter bearbeitet, wird der Hörende nicht den gleichen Höreindruck empfinden wie der, der bei dem Originalereignis im Raum anwesend war.

Ist jedoch z.B. durch Messungen bekannt, welchen Einfluß der Raum auf das Hörgeschehen hat, kann das aufgenommene Audiosignal durch nachträgliche Filterung wieder in das akustische Originalsignal umgewandelt werden.

Dabei ist es prinzipiell gleichgültig, ob die Wiedergabe über Lautsprecher oder Kopfhörer erfolgt.

Bei der Wiedergabe über Kopfhörer kann dabei auch noch die bekannte "Im-Kopf-Lokalisation" vermieden werden, wenn bei der Filterung der binaurale Effekt berücksichtigt wird. Darunter versteht man die Filterung des Audiosignals mit den individuellen Außenohrübertragungsfunktionen des Hörers.

Je genauer die Filter bei der Wiedergabe berücksichtigt werden können, umso naturgetreuer wird der Höreindruck sein.

Aber auch für die Erzielung einer bestimmten Klangfarbe oder zur Anhebung oder Absenkung einzelner Frequenzbereiche können akustische Filter eingesetzt werden. Auch die sogenannten Frequenzweichen, die ein Audiosignal den verschiedenen Lautsprechern einer Box zuweisen, stellen Audiofilter dar.

Im Zeitbereich kann jede Filterung durch eine Faltung mit der entsprechenden Impulsantwort dargestellt werden. Liegen die Audiosignale in digitaler Form vor, stellt jede Faltung eine zeitaufwendige Operation dar, die sich aus einer großen Anzahl von Multiplikationen und Additionen zusammensetzt. Es gibt daher viele Versuche, den für diese Faltung notwendigen Rechenaufwand zu verringern.

Die einfachste Methode besteht darin, eine sogenannte Fensterung vorzunehmen. Dabei wird nicht die gesamte Impulsantwort zur Faltung herangezogen, sondern nur ein Teil von ihr. Die Folge davon ist, daß wichtige Informationen verlorengehen können.

In der Praxis wird die Fensterung so durchgeführt, daß nur der Beginn der Impulsantwort berücksichtigt wird und das Ende, in dem die für die Feinstruktur (z.B. der Nachhall) bei tiefen und mittleren Frequenzen wesentlichen Teile enthalten sind, abgeschnitten wird. Dies gilt insbesondere für Minimalphasenfilter oder annähernd minimalphasige Filter.

In der DE-PS 43 28 620 wurde ein Algorithmus vorgeschlagen, der die Impulsantwort auf jene Teile beschränkt, die gehörmäßig relevant sind. Dadurch liegt zwar keine exakte Lösung des Problems vor, aber durch die Ausnutzung der diversen Verdeckungseffekte kann der Hörende keinen Unterschied zwischen dem wiedergegebenen und dem originalen Audiosignal wahrnehmen. Dabei werden von der Impulsantwort nur jene Teile verwendet, die über einer bestimmten Schwelle liegen. Dadurch kann der Rechenaufwand sehr wesentlich gesenkt werden.

Wie in der erwähnten Patentschrift ausgeführt wurde, sind für eine exakte Berechnung der Faltung bei einer Impulsantwort von zwei Sekunden, einer Abtastrate von 50 kHz und bei einer Bandbreite des Audiosignals von 20 kHz $5 \times 10^9$ Additionen und Multiplikationen pro Sekunde notwendig.

Unter diesen Umständen ist es verständlich, daß Methoden gesucht werden, um den Rechenaufwand für die Faltung zu verringern.

Eine andere bekannte Maßnahme zur Verminderung des Rechenaufwands bei digitaler Filterung ist in dem Aufsatz "Aufwand bei Digitalfiltern gesenkt", beschrieben, der in "Elektronik" Heft 15 1988, S. 82 ff. erschienen ist. Bei diesem Verfahren wird das Audiosignal zusätzlich gefiltert, um die Bandbreite des Audiosignals zu halbieren. Sodann wird das Audiosignal mit der halben Abtastfrequenz gesampelt. Infolge dieser Maßnahme verschwinden sämtliche hohe Tonfrequenzanteile, d.h. das nach der Faltung gewonnene Nutzsignal hat eine deutlich geringere Bandbreite als das ursprüngliche Audiosignal. Mit anderen Worten, die Verminderung des Rechenaufwands wird durch eine Beeinträchtigung des Klangbildes erkauft.

Im Dokument US-A-4 121 296 wird eine mögliche Verringerung des Rechenaufwandes für eine Faltung bei einer geringen Zahl von möglichen Eingangsfolgewerten beschrieben, bei der die Berechnung der Faltung für diese möglichen Werte getrennt erfolgt.

Aufgabe der vorliegenden Erfindung ist es daher, ein Verfahren und eine Vorrichtung anzugeben, das ebenfalls eine wesentliche Verringerung der Anzahl der Rechenoperationen ermöglicht, ohne die hochfrequenten Signalanteile weder des Audiosignals noch der Impulsantwort ungünstig zu beeinflussen.

Diese Aufgabe wird erfindungsgemäß durch das Verfahren mit den Merkmalen des Patentanspruches 1 und die Vorrichtung mit den Merkmalen des Patentanspruches 6 gelöst.

Bei der Berechnung des Ausgangssignals des Filters wird mit einer tatsächlichen oder einer virtuellen Impulsantwort gerechnet, die verglichen mit der echten oder wahren Impulsantwort durch Stufen mit größerer zeitlicher Dauer angenähert ist. -Innerhalb jeder Stufe werden unabhängig von dem tatsächlichen Verlauf der wahren Impulsantwort alle in der Stufe enthaltenen Abtastwerte der Impulsantwort konstant gehalten. Dadurch kann der Rechenaufwand wesentlich reduziert werden. Für die Berechnung eines Abtastwertes des Ausgangssignals des Filters bedeutet dies, daß es genügt, wenn innerhalb eines Intervalls des Audiosignals, das von einer wie oben definierten Stufe der Impulsantwort überdeckt wird, nur die Abtastwerte des Audiosignals aufsummiert werden müssen und anschließend die so gebildete Summe mit dem Abtastwert der Stufe der Impulsantwort multipliziert werden muß. Ersichtlicherweise reicht eine Multiplikation und eine Addition für eine Stufe der angenäherten Impulsantwort aus. Beim Stand der Technik, müssen für den entsprechenden zeitlichen Bereich der Impulsantwort soviel Additionen und Multiplikationen durchgeführt werden, wie Abtastwerte darin enthalten sind.

Andererseits bleiben bei dem neuen Verfahren die akustisch wesentlichen Einflüsse der mittleren und tiefen Frequenzen und/oder des ausklingenden Teils der Impulsantwort des jeweils gewählten Filters erhalten.

Eine weitere Vereinfachung ergibt sich dadurch, daß für den nächsten Zeitpunkt des Ausgangssignals von der vorher erhaltenen Summe über die Abtastwerte des Audiosignals anstelle einer vollständigen neuen Summenbildung nur der wegfallende Abtastwert abgezogen und statt dessen ein neu hinzugekommener Abtastwert aufsummiert wird.

Die Stufen der zur Berechnung verwendeten Impulsantwort - im folgenden angenäherten Impulsantwort genannt - müssen wenigstens halb so groß sein, wie die Periodendauer der höchsten zu berücksichtigenden Frequenz. Angenommen, es sollen mittlere Frequenzen des Hörbereiches noch berücksichtigt werden, beispielsweise um "Im-Kopf-Lokalisation" und andere akustische Effekte zu vermeiden, genügt es, eine angenäherte Impulsantwort zu verwenden, deren Stufen eine zeitliche Länge von größer oder gleich 1/3000 sec aufweisen. Das Audiosignal dagegen hat einen Frequenzbereich, der bis 15 kHz reicht, so daß die zeitlichen Abschnitte der angenäherten Impulsantwort somit 10 mal breiter als die zeitlichen Abschnitte des Audiosignals sind. Unter Berücksichtigung dieses Zusammenhangs und der oben gegebenen Erläuterung verringert sich die Anzahl der notwendigen Multiplikationen und Additionen pro Sekunde gegenüber dem Stand der Technik um den Faktor 5.

Wenn die Dauer der Stufen der angenäherten Impulsantwort noch länger gewählt werden kann, kommen noch größere Verringerungen der Anzahl der erforderlichen Multiplikationen und Additionen zustande.

Anhand der beigefügten Zeichnungen ist ein Ausführungsbeispiel des Gegenstandes der Erfindung dargestellt. Es zeigen:

Fig. 1 den Amplitudengang eines Bandsperrenfilters, das eine Dämpfung im Bereich um 100 Hz aufweist,
Fig. 2 den ausklingenden Teil der Impulsantwort des Filters nach Fig. 1,
Fig. 3 eine nach dem Stand der Technik durch Fensterung abgeänderte Impulsantwort, die aus der Impulsantwort nach Fig. 2 abgeleitet ist,
Fig. 4 den zu der Impulsantwort nach Fig. 3 gehörenden Amplitudengang,
Fig. 5 eine Impulsantwort, die gemäß der Erfindung an die Impulsantwort nach Fig. 2 angenähert ist,
Fig. 6 den zu der Impulsantwort nach Fig. 5 gehörenden Amplitudenverlauf,
Fig. 7 einen Ausschnitt aus einem digitalisierten Audiosignal zusammen mit einem Ausschnitt aus der Impulsantwort gemäß Fig. 5, in starker zeitlicher Dehnung und nicht maßstäblich,
Fig. 8 eine andere Impulsantwort,
Fig. 9 eine aus der Impulsantwort nach Fig. 8 abgeleitete erfindungsgemäße Impulsantwort,
Fig. 10 eine Schaltungsanordnung zur Erzeugung eines gefilterten Audiosignals und
Fig. 11 einen Ausschnitt aus der Architektur eines Faltungsprozessors, wobei die Impulsantwort durch längere zeitliche Abschnitte angenähert ist.

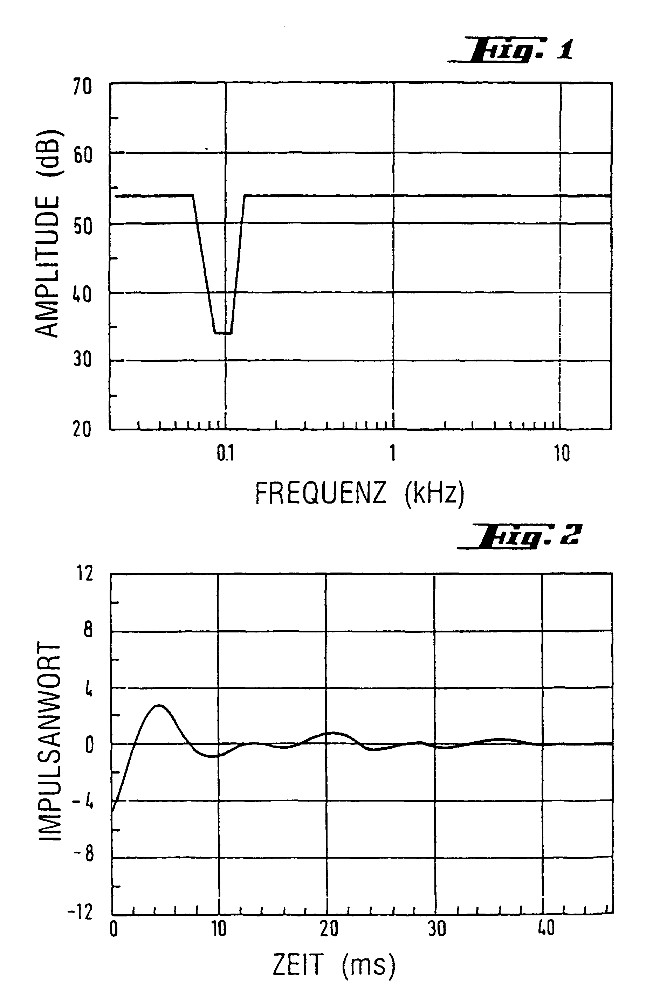

In Fig. 1 ist der Amplitudengang eines Filters veranschaulicht, das Bandsperrencharakteristik im Bereich um 100 Hz aufweist. Die Frequenz ist logarithmisch aufgetragen und es ist erkennbar, daß die Sperrbreite etwa 30 Hz beträgt. Das Filter zeigt in Richtung auf niedrige Frequenzen einen weniger steilen Amplitudenabfall als auf der hochfrequenten Seite. Die Dämpfung beträgt ca. 20 dB. Im übrigen ist der Amplitudenverlauf glatt.

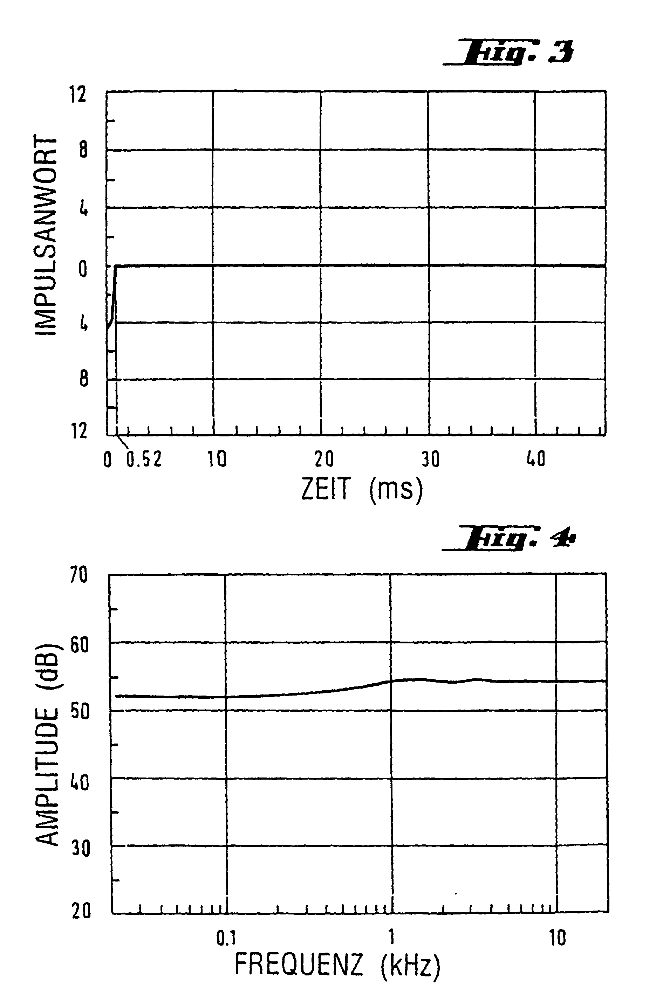

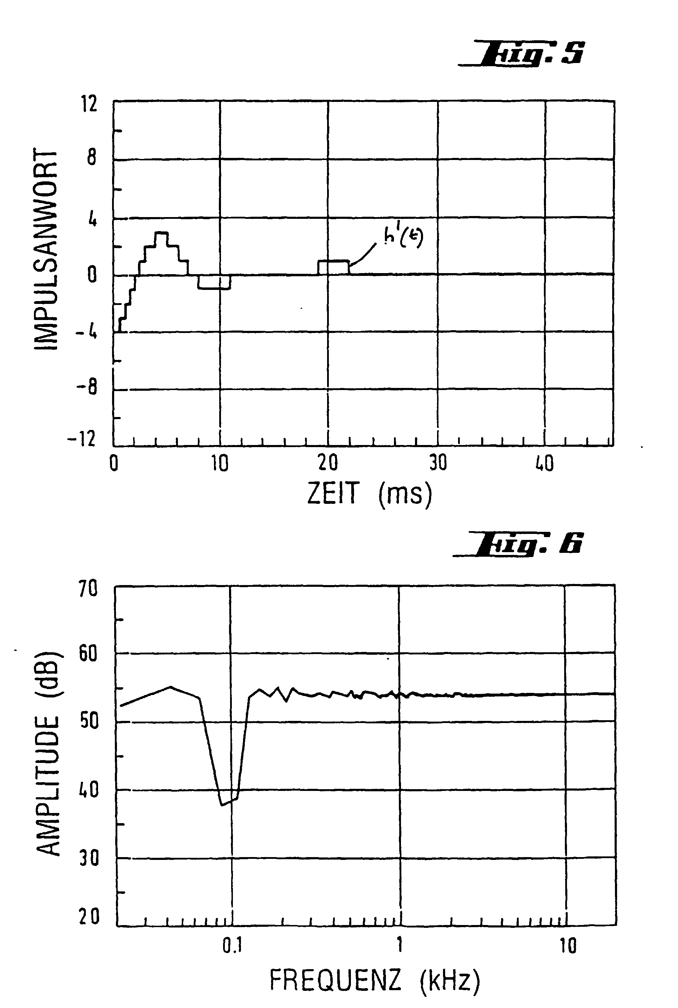

Wenn zu diesem Filter nach Fig. 1 die Impulsantwort rechnerisch bestimmt wird, erhält man im ausklingenden Teil einen zeitlichen Verlauf, wie er in Fig. 2 gezeigt ist. Dieser Teil der Impulsantwort hat eine Dauer von etwa 40 ms und dabei etwa zehn erkennbare Nulldurchgänge. Mit zunehmender Zeit wird die Amplitude der Impulsantwort so klein, daß keine nennenswerte Beeinflussung des Audiosignals mehr zustandekommt.

Die Filterung eines Audiosignals mit Hilfe des Filters, dessen Amplitudengang Fig. 1 veranschaulicht, kann rechnerisch dadurch erfolgen, daß das Audiosignal mit der Impulsantwort des Filters gefaltet wird. Zu diesem Zweck wird das Audiosignal unter Berücksichtigung des Abtasttheorems digitalisiert, d.h. es wird in eine Treppenfunktion umgewandelt. Dasselbe geschieht mit der Impulsantwort, wobei die Samplingrate für die Impulsantwort gleich der Samplingrate des Audiosignals gewählt wird.

Infolge der Digitalisierung wird aus dem Faltungsintegral eine Faltungssumme, die lautet

$$O_t = \sum_{i=0}^{N} s_{t-i} \cdot h_i$$

Dabei bedeuten:

$O_t$ = die Amplitde des Ausgangssignals des Filters zum Zeitpunkt t,

$h_i$ = der i-te Abtastwert der Impulsantwort und

$s_{t-i}$ = der Abtastwert des Audiosignals zum Zeitpunkt t-i

N = die Anzahl der Abtastwerte der Impulsantwort

Wie unschwer aus der Gleichung zu erkennen ist, sind für jeden Zeitpunkt t aufeinanderfolgend soviele Produkte zu berechnen, wie die Impulsantwort ausgedrückt in der Anzahl ihrer Abtastwerte lang ist. Die erhaltenen Produkte sind sodann aufzusummieren. Da diese Operation in Echtzeit durchgeführt werden muß, werden sehr leistungsfähige Rechner benötigt, um die Rechenzeit zu vermindern.

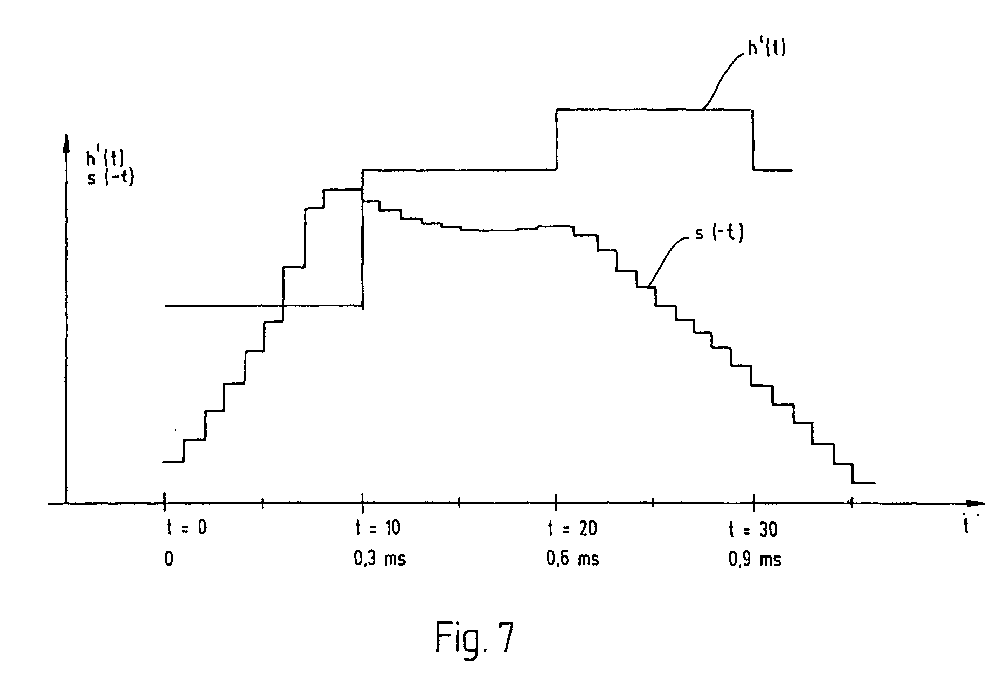

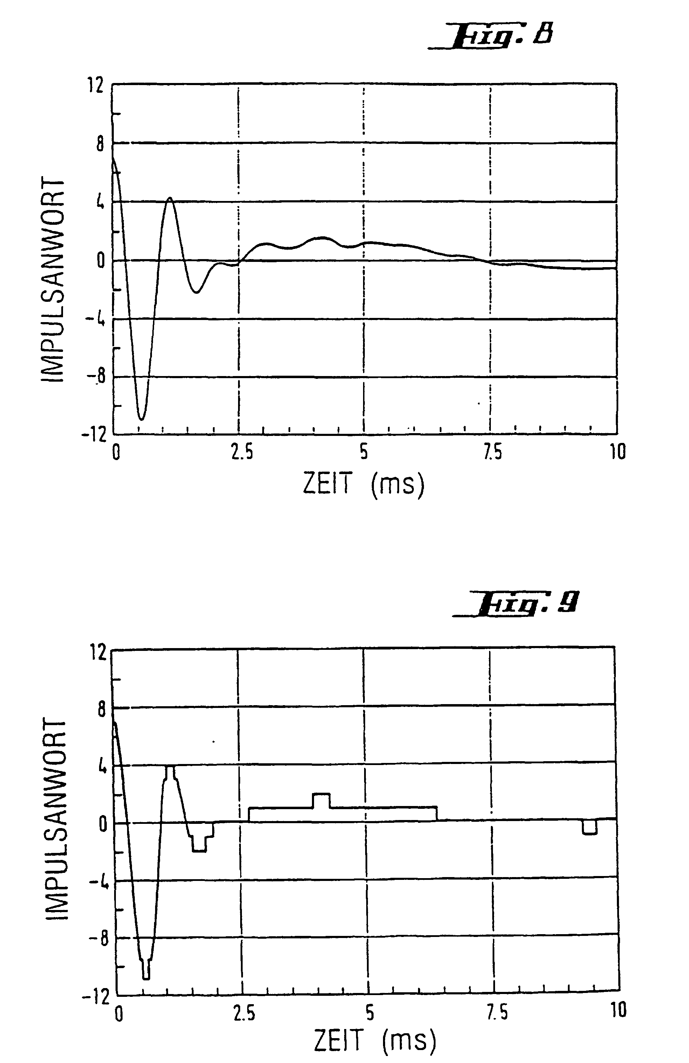

Wenn zur Verminderung des Rechenaufwandes das Fensterverfahren verwendet wird, reduziert sich die Impulsantwort nach Fig. 2 zu der abgeleiteten Impulsantwort nach Fig. 3. Von der tatsächlichen Impulsantwort bleibt lediglich ein Abschnitt von insgesamt 0,5 ms Dauer übrig, während der Rest zu Null wird. Dadurch reduziert sich zwar erheblich der Rechenaufwand, doch der Amplitudengang eines Filters mit einer Impulsantwort gemäß Fig. 3 hätte mit dem Amplitudengang des gewünschten Filters keinerlei Ähnlichkeit mehr, wie dies Fig. 4 erkennen läßt. Diese Figur zeigt den Amplitudengang des Filters mit der Impulsantwort nach Fig. 3. Die Bandsperrencharakteristik bei 100 Hz ist vollständig verschwunden und statt dessen entsteht eine geringfügige Absenkung der Amplitude für praktisch alle Frequenzen kleiner 1 kHz.

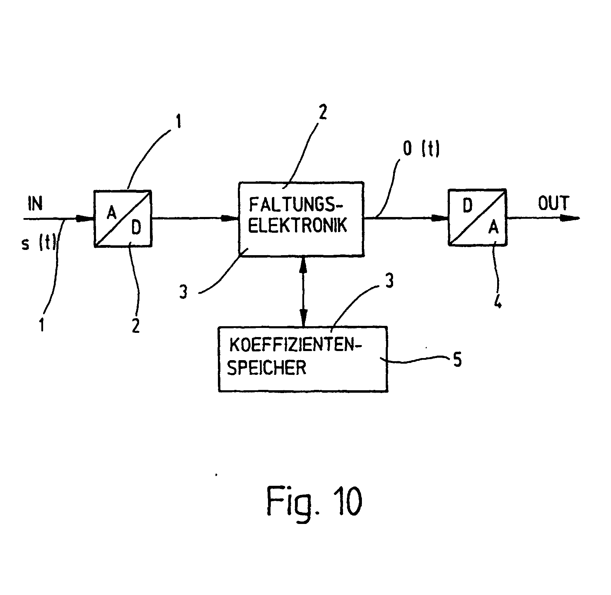

Wird hingegen die Impulsantwort erfindungsgemäß abgeleitet, entsteht eine angenäherte Impulsantwort h'(t), von der wiederum nur der ausklingende Teil in Fig. 5 gezeigt ist. Je nach verwendetem Verfahren tritt diese angenäherte Impulsantwort meßtechnisch auf oder ist nur virtuell bei der Berechnung vorhanden. Im weiteren wird zum besseren Verständnis so getan als sei die angenäherte Impulsantwort vorhanden. Zum Erzeugen dieser Impulsantwort h'(t) werden Stufen verwendet, deren Dauer etwa 10-mal größer ist als das Abtastintervall.

Zur weiteren Vereinfachung werden außerdem Amplitudenwerte der Impulsantwort h(t) nach Fig. 2, die unterhalb einer bestimmten Schwelle liegen, auf Null gesetzt. Die Transformation der vollständigen angenäherten Impulsantwort h'(t) in den Frequenzbereich führt zu dem Amplitudengang nach Fig. 6. Der Amplitudenverlauf bei sehr tiefen Frequenzen ist zwar nicht mehr, wie bei dem idealen Verlauf nach Fig. 1, eben, sondern zeigt einen geringfügigen Höcker bei ca. 50 Hz, doch ist die Bandsperrenfunktion um 100 Hz fast genauso gut ausgeprägt, wie in Fig. 1. Bei höheren Frequenzen oberhalb etwa 110 Hz ist der Amplitudenverlauf, abgesehen von geringen Schwankungen, verhältnismäßig eben. Die Schwankungen sind so gering, daß sie den Höreindruck praktisch nicht verfälschen.

Infolge der wesentlich gröberen Rasterung der angenäherten Impulsantwort h'(t) vereinfacht sich die Faltungssumme erheblich. Um diesen Vorteil besser zu verstehen, zeigt Fig. 7 einen Ausschnitt aus dem zu filternden Audiosignal s(t) mit einem darüber gelegten Ausschnitt aus der angenäherten Impulsantwort h'(t) nach Fig. 5.

Die Darstellung der Amplitudenverhältnisse ist dabei nicht maßstäblich.

Infolge der Stufung der angenäherten Impulsantwort h'(t) fallen bei dem gewählten Ausführungsbeispiel in ein Intervall zwischen zwei Stufenübergängen der angenäherten Impulsantwort h'(t) zehn Abtastwerte des Audiosignals s(t). Um also den Beitrag des Audiosignals s(t) beispielsweise für den Bereich zwischen t = 1 und t = 10 gefaltet mit h'(t) für t = 1...10 zu berechnen, genügt es, wenn in dem Bereich zwischen t = 1 und t = 10 die Summe der einzelnen Abtastwerte St und diese Summe sodann mit einem der Abtastwerte der Impulsantwort für diesen Bereich zwischen t = 1 und t = 10 multipliziert wird. An die Stelle von insgesamt zehn Einzelprodukten, die anschließend summiert werden, tritt bei der erfindungsgemäßen Lösung die Summation von zehn Gliedern und eine Multiplikation, was eine deutliche Rechenzeitverminderung bedeutet.

Eine weitere Verminderung des notwendigen Rechenaufwandes ergibt sich daraus, daß für den Punkt t = 2 nicht die ganze Summe neu gebildet werden muß. Es reicht aus, wenn von dem Resultat das vorher für den Bereich von t = 1 und bis t = 10 berechnet wurde, der Abtastwert $s_{t=-1}$ abgezogen und statt dessen der Abtastwert $s_{t=-11}$ hinzuaddiert wird. Das sodann erhaltene Resultat wird erneut mit einem der Abtastwerte für den Bereich t = 1...10 der angenäherten Impulsantwort h'(t) multipliziert.

Die im Ausschnitt der Fig. 7 gezeigte angenäherte Impulsantwort kann auch als Impulsantwort aufgefaßt werden, die mit derselben Abtastrate erzeugt wurde wie das Audiosignal, bei der aber über mehrere - im gezeigten Fall 10 - Abtastintervalle die Abtastwerte unabhängig vom wahren Verlauf der mit der hohen Rate gesampelten Impulsantwort konstant gehalten sind. Oder die angenäherte Impulsantwort kann als eine Impulsantwort aufgefaßt werden, deren Samplingrate scheinbar um den entsprechenden Betrag langsamer ist, d.h. die Abtastwerte der Impulsantwort haben einen zeitlichen Abstand voneinander, der größer ist als das Abtastintervall des Audiosignals.

Zweckmäßigerweise wird die Stufung der angenäherten Impulsantwort so gewählt, daß der Amplitudengang und gegebenenfalls auch der Phasengang, der der Einfachheit halber in den obigen Figuren nicht gesondert dargestellt ist, optimal an den gewünschten Verlauf angepaßt sind.

Ferner ist es möglich, eine Optimierung zu erreichen, indem die Impulsantwort nicht mit gleichlange dauernden Stufen angenähert wird, sondern die Dauer der Stufen wird im Verlauf der Impulsantwort verändert, in dem Sinne, daß der Fehler zwischen der angenäherten Impulsantwort und der original- oder idealen Impulsantwort so klein wie möglich wird. Eine solche Ausführung ist beispielsweise in den Fig. 8 und 9 gezeigt. Fig. 8 veranschaulicht eine theoretische oder ideale Impulsantwort, die im Anschluß an einen verhältnismäßig hochfrequenten Kopf, der nach etwa 2,5 ms endet, einen Ausklingteil mit wesentlich tieferen Frequenzen aufweist. Die Annäherung der gestuften Impulsantwort geschieht hierbei vorzugsweise mit einer geringen Stufenbreite im Bereich des Kopfes der Impulsantwort, also in dem Bereich zwischen 0 und 2,5 ms, während die Stufenbreite im "Schwanz" der Impulsantwort, abgesehen bei einem Höcker bei ca. 3 ms extrem vergrößert wird.

Schließlich ist es möglich, wie ebenfalls Fig. 9 erkennen läßt, im Bereich des Kopfes der Impulsantwort mit einer Dauer für die Stufen zu arbeiten, die mit dem Abtastintervall des Audiosignals übereinstimmt, was in Fig. 9 durch einen abschnittsweise glatten Kurvenverlauf (glatt im Sinne von im wesentlichen stufenfrei) im Bereich zwischen 0 und ca. 0,5 ms sowie im Bereich zwischen ca. 0,75 und 1,0 und schließlich in einem weiteren Teil zwischen 1,3 und 1,5 ms gezeigt ist.

Das oben ausführlich geschilderte Filterverfahren läßt sich mit der in Fig. 10 gezeigten Schaltung realisieren. Diese Schaltung weist einen Analog-Digital-Wandler 1 auf, in den das Audiosignal s(t) als Analog-Signal eingespeist wird. Das Eingangssignal s(t) wird in dem Analog-Digital-Wandler 1 in ein digitalisiertes Audiosignal umgewandelt, wobei die Abtastfrequenz zwecks Erfüllung des Abtasttheorems wenigstens doppelt so groß ist wie die höchste in dem Audiosignal s(t) enthaltene Frequenz. Das auf diese Weise digitalisierte Audiosignal s(t) gelangt in eine Faltungselektronik 2, die im wesentlichen ein Rechenwerk ist, an den ein Speicher 3 angeschlossen ist. In dem Speicher 3 sind, abgesehen von dem Programm, auch die Abtastwerte der erfindungsgemäß angenäherten Impulsantwort h'(t) des gewünschten Filters abgelegt. In dem Rechenwerk 2 wird die weiter oben angegebene Summenbildung und Multiplikation zur angenäherten Berechnung des Faltungsintegrals durchgeführt. Das so erhaltene Signal stellt das Ausgangssignal O(t) dar, und zwar in digitalisierter Form. Soweit es keiner weiteren Bearbeitung unterzogen werden muß, kann es in einem nachgeschalteten Digital-Analog-Wandler 4 in ein analoges gefiltertes Audiosignal zurückgewandelt werden.

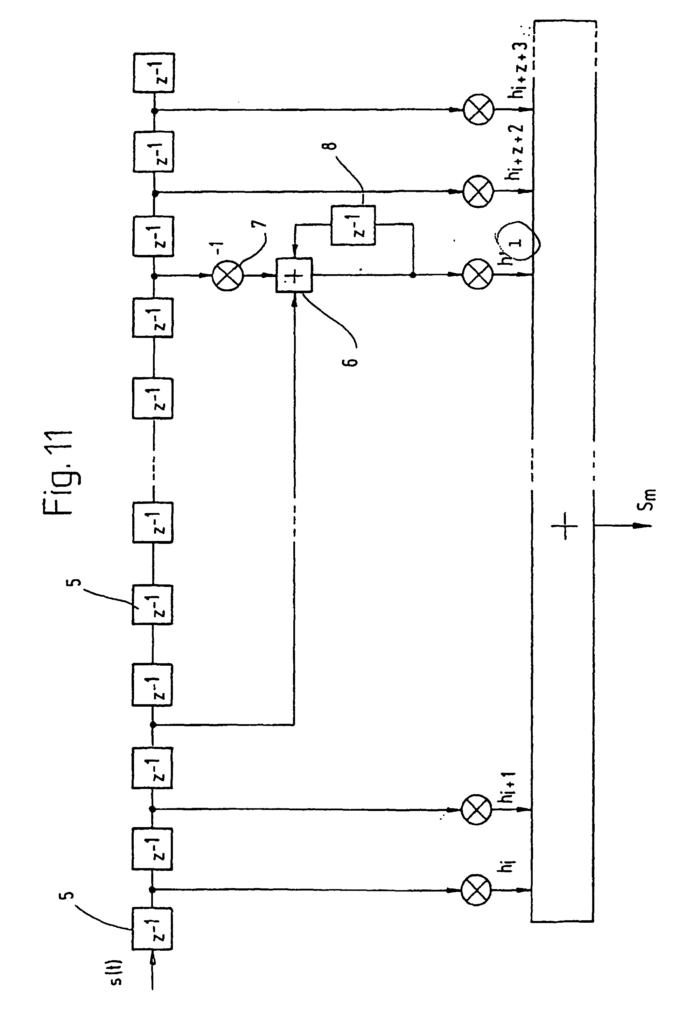

Fig. 11 zeigt die Architektur einer Einrichtung, die gemischt unter Verwendung eines FIR-Filters und der erfindungsgemäßen Faltungsberechnung arbeitet. Der Digitalisierung mit der vorgegebenen Abtastfrequenz entsprechen Verzögerungsglieder 5, wobei im Falle der weniger lange dauernden Stufen nach jedem Verzögerungsglied 5 der eingespeiste Wert des Audiosignals s(t) mit den entsprechenden Abtastwerten hi der Impulsantwort bewertet wird. In dem Bereich, in dem über einen vergleichsweise weiten Zeitraum mit lange dauernden Stufen die Impulsantwort abgearbeitet wird, wird das Signal über eine entsprechende Anzahl von Verzögerungsgliedern 5 ohne sonstige Bearbeitung weitergetaktet und es wird in einem Summierer 6 der neu eintreffende Abtastwert addiert, während der letzte aus dem Intervall verschwindende Abtastwert nach einer Vorzeichenumkehr in der Stufe 7 von dem ursprünglichen, in einem Speicher 8 gehaltenen Summenwert abgezogen wird. Das so gewonnene Ergebnis wird mit den Abtastwerten $h'_1$ der Impulsantwort multipliziert, wobei $h'_1$ der erfindungsgemäß erzeugte Wert ist.

Auch hierbei wird eine deutliche Vereinfachung erreicht, insofern, als das FIR-Filter wesentlich weniger Anzapfungen benötigt.

Bei digitalisierten Audiosignalen erfolgt die Filterung, indem das digitalisierte Audiosignal mit einer ebenfalls digitalisierten Impulsantwort gefaltet wird. Ohne besondere Maßnahmen benötigt die Faltung eine sehr große Anzahl von Rechenoperationen, die in Echtzeit ausgeführt werden müssen.

Um diese Anzahl zu verringern, wird die Impulsantwort angenähert. Bei der angenäherten Impulsantwort werden in aneinander angrenzenden Intervallen innerhalb des betreffenden Intervalls die Abtastwerte unabhängig vom wahren Verlauf der zugrundeliegenden Impulsantwort über mehrere Abtastintervalle konstant gehalten. Die Größe, auf die die Abtastwerte in jedem Intervall konstant gehalten werden, entspricht der Größe eines gewillkürten, in das betreffende Intervall fallenden Abtastwerts der zugrundeliegenden Impulsantwort, z.B. des jeweils ersten in das betreffende Intervall fallenden Abtastwerts der Originalimpulsantwort.

**Patentansprüche**

1. Verfahren zur Filterung eines Audiosignals, mit den Schritten:

das Audiosignal wird in digitalisierter Form bereitgestellt, wobei das Abtastintervall halb so groß oder weniger als halb so groß ist wie die Periodendauer der größten in dem Audiosignal zu erwartenden Frequenz,
eine digitalisierte Impulsantwort entsprechend der gewünschten Filterwirkung wird bereitgestellt und
aus Abtastwerten der Impulsantwort und Abtastwerten des Audiosignals wird eine Faltungssumme gebildet, wobei

(i) in wenigstens einem zeitlichen Abschnitt der Impulsantwort, der kürzer ist als die Impulsantwort, mehrere benachbarte Abtastwerte der Impulsantwort ein zugehöriges Intervall definieren,
(ii) innerhalb dieses so definierten Intervalls die zu dem so definierten Intervall gehörenden Abtastwerte der Impulsantwort gleich einem Wert gesetzt werden, der eine Funktion eines oder mehrerer der in das so definierte Intervall fallenden Abtastwerte der digitalisierten Impulsantwort ist, und

(iii) die Schritte (i) und (ii) gegebenenfalls mehrfach wiederholt werden, mit der Maßgabe, daß sich die so definierten Intervalle nicht überlappen,

so daß zur Berechnung der Faltungssumme in zumindest einem zeitlichen Abschnitt eine zeitlich vergröberte Impulsantwort zur Faltung verwendet wird und daß im übrigen die Impulsantwort unverändert zur Faltung verwendet wird.

2. Verfahren nach Anspruch 1, **dadurch gekennzeichnet, daß** die zeitliche Dauer eines so definierten Intervalls um wenigstens den Faktor 3, vorzugsweise um wenigstens den Faktor 10, höchst vorzugsweise um den Faktor 50 größer ist als das Abtastintervall.

3. Verfahren nach Anspruch 1, **dadurch gekennzeichnet, daß**, wenn die Impulsantwort des Filters Nulldurchgänge aufweist, die Nulldurchgänge der zu der Berechnung der Faltungssumme verwendeten Abtastwerte der Impulsantwort mit den Nulldurchgängen der Impulsantwort des Filters zusammenfallen.

4. Verfahren nach Anspruch 1, **dadurch gekennzeichnet, daß** die Breite der so definierten Intervalle über einen zeitlichen Abschnitt der Länge der Impulsantwort oder über die gesamte Impulsantwort konstant ist.

5. Verfahren nach Anspruch 1, **dadurch gekennzeichnet, daß** bei der Berechnung der Faltungssumme diejenigen Abtastwerte der Impulsantwort Null gesetzt sind, in denen die Amplitude der Impulsantwort des Filters kleiner als ein vorgegebener Wert ist.

6. Vorrichtung zur Filterung eines digitalisierten Audiosignals, bei dem das Abtastintervall halb so groß oder weniger als halb so groß ist, wie die Periodendauer der größten in dem Audiosignal zu erwartenden Frequenz,
mit einer Recheneinrichtung, die einen Eingang aufweist, dem die Abtastwerte des digitalisierten Audiosignals zugeführt werden,
mit einer eine Speichereinrichtung, in der Werte abgelegt sind, die Abtastwerten einer vorbestimmten Impulsantwort entsprechen, wobei

(i) in wenigstens einem zeitlichen Abschnitt der Impulsantwort, der kürzer ist als die Impulsantwort, mehrere benachbarte Abtastwerte der Impulsantwort ein zugehöriges Intervall definieren,

(ii) innerhalb dieses so definierten Intervalls die zu dem so definierten Intervall gehörenden Abtastwerte der Impulsantwort gleich einem Wert gesetzt werden, der eine Funktion eines oder mehrerer der in das so definierte Intervall fallenden Abtastwerte der digitalisierten Impulsantwort ist, und

(iii) die Schritte (i) und (ii) gegebenenfalls mehrfach wiederholt werde, mit der Maßgabe, daß sich die so definierten Intervalle nicht überlappen,

so daß zur Berechnung der Faltungssumme in zumindest einem zeitlichen Abschnitt eine zeitlich vergröberte Impulsantwort zur Faltung verwendet wird und daß im übrigen die Impulsantwort unverändert zur Faltung verwendet wird.

7. Vorrichtung nach Anspruch 6, **dadurch gekennzeichnet, daß** die zeitliche Dauer eines so definierten Intervalls um wenigstens den Faktor 3, vorzugsweise um wenigstens den Faktor 10, höchst vorzugsweise um den Faktor 50 größer ist als das Abtastintervall.

8. Vorrichtung nach Anspruch 6, **dadurch gekennzeichnet, daß**, wenn die Impulsantwort des Filters Nulldurchgänge aufweist, die Nulldurchgänge der zu der Berechnung der Faltungssumme verwendeten Abtastwerte der Impulsantwort mit den Nulldurchgängen der Impulsantwort des Filters zusammenfallen.

9. Vorrichtung nach Anspruch 6, **dadurch gekennzeichnet, daß** die Breite eines so definierten Intervalls über einen zeitlichen Abschnitt der Länge der Impulsantwort oder über die gesamte Impulsantwort konstant ist.

10. Vorrichtung nach Anspruch 6, **dadurch gekennzeichnet, daß** bei der angenäherten Impulsantwort jene Bereiche Null gesetzt sind, in denen die Amplitude der Impulsantwort des Filters kleiner als ein vorgegebener Wert ist.

**Claims**

1. Method for filtering an audio signal, comprising the following steps:

the audio signal is provided in digitized form, wherein the sampling interval is half as great or less than half as great as the period of the maximum frequency to be expected in the audio signal,

a digitized pulse response corresponding to the desired filtering action is provided and

a convolution sum is formed from sample values of the pulse response and sample values of the audio signal, wherein

(i) in at least one time section of the pulse response which is shorter than the pulse response a plurality of adjacent sample values of the pulse response define an associated interval,

(ii) within this interval thus defined the sample values of the pulse response which are associated with the interval thus defined are equated with a value which is a function of one or more of the sample values of the digitized pulse response which fall within the interval thus defined, and

(iii) the steps (i) and (ii) are optionally repeated several times, provided that the intervals thus defined do not overlap,

so that a time-coarsened pulse response is used for the convolution in order to calculate the convolution sum in at least one time section, and that the pulse response is otherwise used unchanged for the convolution.

2. Method according to Claim 1, **characterised in that** the time duration of an interval thus defined is greater than the sampling interval by at least the factor 3, preferably by at least the factor 10, most preferably by the factor 50.

3. Method according to Claim 1, **characterised in that**, if the pulse response of the filter comprises zero crossings, the zero crossings of the sample values of the pulse response which are used to calculate the convolution sum coincide with the zero crossings of the pulse response of the filter.

4. Method according to Claim 1, **characterised in that** the width of the intervals thus defined is constant over a time section of the length of the pulse response or over the entire pulse response.

5. Method according to Claim 1, **characterised in that** the sample values of the pulse respose in which the amplitude of the pulse response of the filter is lower than a predetermined value are equated with zero when calculating the convolution sum.

6. Device for filtering a digitized audio signal, in which the sampling interval is half as great or less than half as great as the period of the maximum frequency to be expected in the audio signal, with a computing device (2) comprising an input to which the sample values of the digitized audio signal are supplied, with a memory device (3) in which values which correspond to sample values of a predetermined pulse response are stored, wherein

(i) in at least one time section of the pulse response which is shorter than the pulse response a plurality of adjacent sample values of the pulse response define an associated interval,

(ii) within this interval thus defined the sample values of the pulse response which are associated with the interval thus defined are equated with a value which is a function of one or more of the sample values of the digitized pulse response which fall within the interval thus defined, and

(iii) the steps (i) and (ii) are optionally repeated several times, provided that the intervals thus defined do not overlap,

so that a time-coarsened pulse response is used for the convolution in order to calculate the convolution sum in at least one time section, and that the pulse response is otherwise used unchanged for the convolution.

7. Device according to Claim 6, **characterised in that** the time duration of an interval thus defined is greater then the sampling interval by at least the factor 3, preferably by at least the factor 10, most preferably by the factor 50.

8. Device according to Claim 6, **characterised in that**, if the pulse response of the filter comprises zero crossings, the zero crossings of the sample values of the pulse response which are used to calculate the convolution sum coincide with the zero crossings of the pulse response of the filter.

9. Device according to Claim 6, **characterised in that** the width of an interval thus defined is constant over a time section of the length of the pulse response or over the entire pulse response.

10. Device according to Claim 6, **characterised in that** the regions in which the amplitude of the pulse response of the filter is lower than a predetermined value are equated with zero in the approximate pulse response.

**Revendications**

1. Dispositif pour le filtrage d'un signal audio, comprenant les étapes consistant à :

préparer le signal audio sous forme numérisable, l'intervalle d'échantillonnage ayant une taille égale à la moitié ou à moins de la moitié de la durée de la période de la fréquence maximale à laquelle on peut s'attendre dans le signal audio,

on prépare une réponse impulsionnelle numérisée conformément à l'action de filtre désirée, et à partir des valeurs d'échantillonnage, on forme une somme de convolution à partir des valeurs d'échantillonnage de réponse impulsionnelle et des valeurs d'échantillonnage du signal audio, auquel cas

(i) dans au moins une section temporelle de la réponse impulsionnelle, qui est plus courte que la réponse impulsionnelle, plusieurs valeurs voisines d'échantillonnage de la réponse impulsionnelle définissent un intervalle associé,
(ii) à l'intérieur de cet intervalle ainsi défini, on règle les valeurs d'échantillonnage de la valeur impulsionnelle, associées à l'intervalle ainsi défini, égales à une valeur qui est fonction d'une ou de plusieurs valeurs d'échantillonnage, qui entrent dans l'intervalle ainsi défini, de la réponse impulsionnelle numérisée, et
(iii) on répète les étapes (i) et (ii) éventuellement plusieurs fois avec la condition selon laquelle les intervalles ainsi définis ne se chevauchent pas:

de telle sorte que pour le calcul de la somme de convolution qui est utilisée dans au moins une section temporelle, on utilise une réponse impulsionnelle agrandie dans le temps pour la convolution, et et qu'ailleurs on utilise la réponse impulsionnelle inchangée pour la convolution.

**2.** Procédé selon la revendication 1, **caractérisé en ce que** la durée d'un intervalle de temps ainsi défini est supérieure au moins du facteur 3, de préférence au moins du facteur 10 et au maximum de préférence du facteur 50 à l'intervalle d'échantillonnage.

**3.** Procédé selon la revendication 1, **caractérisé en ce que** lorsque la réponse impulsionnelle du filtre présente des passages par zéro, les passages par zéro des valeurs d'échantillonnage, utilisées pour le calcul de la somme de convolution, de la réponse impulsionnelle coïncident avec les passages par zéro de la réponse impulsionnelle du filtre.

**4.** Procédé selon la revendication 1, **caractérisé en ce que** la largeur des intervalles ainsi définis est constante sur une section temporelle ayant la longueur de la réponse impulsionnelle sur l'ensemble de la réponse impulsionnelle.

**5.** Procédé selon la revendication 1, **caractérisé en ce qu'**on fixe à zéro pour le calcul de la somme de convolution les valeurs d'échantillonnage de la réponse impulsionnelle, au niveau desquelles l'amplitude de la réponse impulsionnelle du filtre est inférieure à une valeur prédéterminée.

**6.** Dispositif pour le filtrage d'un signal audio numérisé, dans lequel l'intervalle d'échantillonnage est égal à la moitié ou à moins de la moitié de la durée de la période de la fréquence maximale à laquelle on peut s'attendre dans le signal audio, comportant un dispositif de calcul (2), qui possède une entrée, à laquelle sont envoyées les valeurs d'échantillonnage du signal audio numérisé, un dispositif de mémoire (3), dans lequel sont mémorisées des valeurs qui correspondent à des valeurs d'échantillonnage d'une réponse impulsionnelle prédéterminée,

(i) dans au moins une section temporelle de la réponse impulsionnelle, qui est plus courte que la réponse impulsionnelle, plusieurs valeurs voisines d'échantillonnage de la réponse impulsionnelle définissent un intervalle associé,
(ii) à l'intérieur de cet intervalle ainsi défini, les valeurs d'échantillonnage, appartenant à l'intervalle ainsi défini, de la réponse impulsionnelle sont positionnées égales à une valeur qui est une fonction d'une ou de plusieurs valeurs d'échantillonnage, qui entre dans l'intervalle ainsi défini, de la réponse impulsionnelle numérisée, et
(iii) on répète éventuellement plusieurs fois les étapes (i) et (ii) avec la condition que les intervalles ainsi définis ne se chevauchent pas,

de telle sorte que pour le calcul de la somme de convolution qui est utilisée dans au moins une section temporelle, on utilise une réponse impulsionnelle agrandie dans le temps pour la convolution, et et qu'ailleurs on utilise la réponse impulsionnelle inchangée pour la convolution.

**7.** Dispositif selon la revendication 6, **caractérisé en ce que** la durée d'un intervalle de temps ainsi défini est supérieure au moins du facteur 3, de préférence au moins du facteur 10 et au maximum de préférence du facteur 50 à l'intervalle d'échantillonnage.

**8.** Dispositif selon la revendication 6, **caractérisé en ce que** lorsque la réponse impulsionnelle du filtre présente des passages par zéro, les passages par zéro des valeurs d'échantillonnage, utilisées pour le calcul de la somme de convolution, de la réponse impulsionnelle coïncident avec les passages par zéro de la réponse impulsionnelle du filtre.

**9.** Dispositif selon la revendication 6, **caractérisé en**

**ce que** la largeur des intervalles ainsi définis est constante sur une section temporelle ayant la longueur de la réponse impulsionnelle ou sur l'ensemble de la réponse impulsionnelle.

10. Dispositif selon la revendication 6, **caractérisé en ce que** dans la réponse impulsionnelle approximée, les zones, dans lesquelles l'amplitude de la réponse impulsionnelle du filtre est inférieure à une valeur prédéerminée, sont positionnées à zéro.

*Fig. 1*

AMPLITUDE (dB)

70

60

50

40

30

20

0.1                    1                    10

FREQUENZ (kHz)

*Fig. 2*

12

8

4

0

-4

-8

-12

0          10          20          30          40

ZEIT (ms)

IMPULSANWORT

Fig. 3

Fig. 4

*Fig. 5*

*Fig. 6*

Fig. 7

**Fig. 8**

**Fig. 9**

Fig. 10

Fig. 11

EP 0 777 326 B1